# EUROPEAN PATENT SPECIFICATION

(11) **EP 0 448 352 B1**
(45) Date of publication and mention of the grant of the patent: **26.07.1995**
(21) Application number: 91302370.1
(22) Date of filing: 19.03.1991
(51) Int. Cl.: H04N 5/21

(54) **Transversal equalizer**
Transversalentzerrer
Egaliseur transversal

(30) Priority: 19.03.1990 JP 70639/90
(43) Date of publication of application: 25.09.1991
(73) Proprietor: KABUSHIKI KAISHA TOSHIBA, Kawasaki-shi, Kanagawa-ken 210 (JP)
(72) Inventor: Iga, Hiroyuki, c/o Intellectual Property Div., Minato-ku, Tokyo (JP); Nishikawa, Masaki, c/o Intellectual Property Div., Minato-ku, Tokyo (JP)
(74) Representative: Muir, Ian R.

(56) References cited:
- EP-A- 0 072 247

## Description

The present invention relates generally to a transversal equalizer, and more particularly, to a transversal equalizer which is composed of recursive and non-recursive filters connected in series and is suited for real-time filter processing of input signals.

In recent years, a GCR (ghost canceller reference) signal has been inserted in the vertical blanking period as the reference signal for de-ghosting in response to demands for high quality pictures in TV broadcasting. Transversal equalizers have been adopted by TV sets for cancelling ghost images through waveform equalization using the GCR signal.

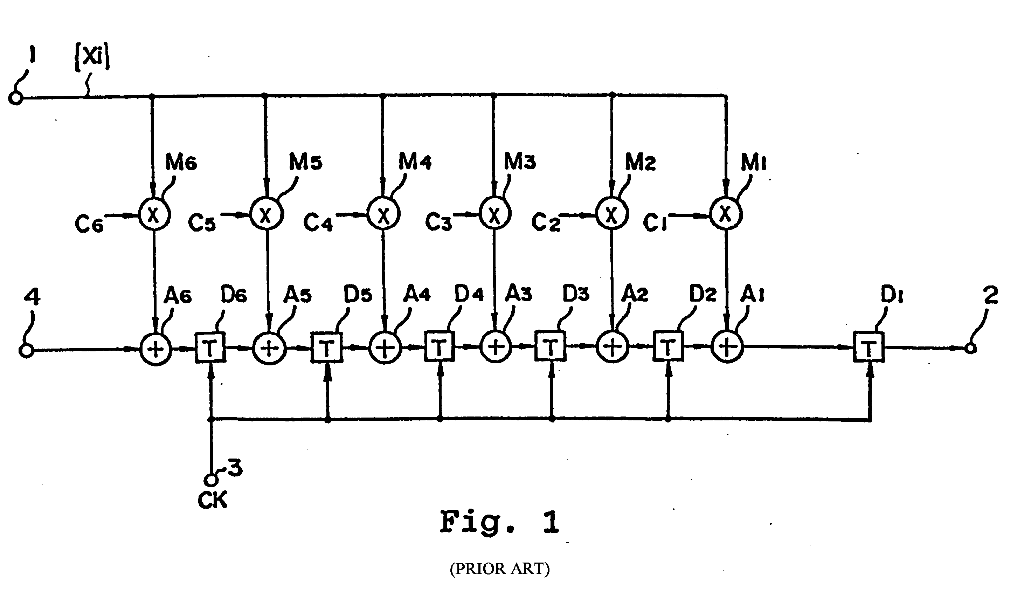

Shown in FIGURE 1 is a circuit diagram showing the transversal equalizer used for real-time waveform equalization. The circuit shown in FIGURE 1 is referred to in, for example, Shri Goyal et al., "Performance Evaluations of Selected Automatic Deghosting Systems for Television", "IEEE Transactions on Consumer Electronics", Vol. CE-26, pp. 100-120 (February 1980) and is called a 6-taps transversal equalizer.

An input signal is sampled at every T seconds and this input sample value Xi is applied to the input terminal 1. This input sample value Xi is applied to the multipliers M1 through M6, respectively and multiplied by coefficients (hereinafter called tap coefficients) C1 through C6.

Outputs of the multipliers M1 through M6 are applied to the adders A1 through A6, respectively. Outputs from the adders A1 through A6 are delayed by the delay units D1 through D6, respectively and applied to the output terminal 2 and the adders A1 through A5 in the next filter stage.

Further, the delay units D1 through D6 are driven by the clock CK having a period T seconds supplied through the input terminal 3, and output the input signals delayed by T seconds. At the output terminal 2, an output based on a tap coefficient appears and it is possible to equalize the transmission lines by setting the tap coefficient.

Further, signals from a preceding stage may be input to the cascade input terminal 4. This signal is added to the output from the multiplier M6 in the adder A6.

Now, assuming that an input sample value Xi is δ function {δi}, its impulse response {αi} is α1 = C1, α2 = C2, ..., α6 = C6. As the length of a train of impulse responses is the same as the number of taps, a longer train of impulse responses is obtained by increasing the number of taps. That is, filtering time is extended by increasing the number of taps.

The range of delay times in which ghost can be cancelled by GCR signal is 44.7 »s of GCR signal width. See, for example, Susumu Takayama et al., "Deghosting Reference Signal System", "1989 National Convention Record of the Institute of Television Engineers of Japan", pp. 239-240.

As described above, the length of the filtering time is determined by the number of taps and the number of taps required to obtain the range of 44.7 »s delay time is expressed by 44.7 »s/T (clock period). Normally, the clock frequency in the TV signal digital processing is set at 4 times the chromatic sub-carrier frequency (14.31818 MHz) and the clock period T is 69.84 »s. Thus in de-ghosting using a GCR signal as many as 640 taps are needed.

Transversal equalizers have normally been made in integrated circuits (IC) and with the advanced degree of integration, 64 taps have been integrated in a single chip like TF-IC adopted in Toshiba's ghost clean TV tuner (TT-GC9).

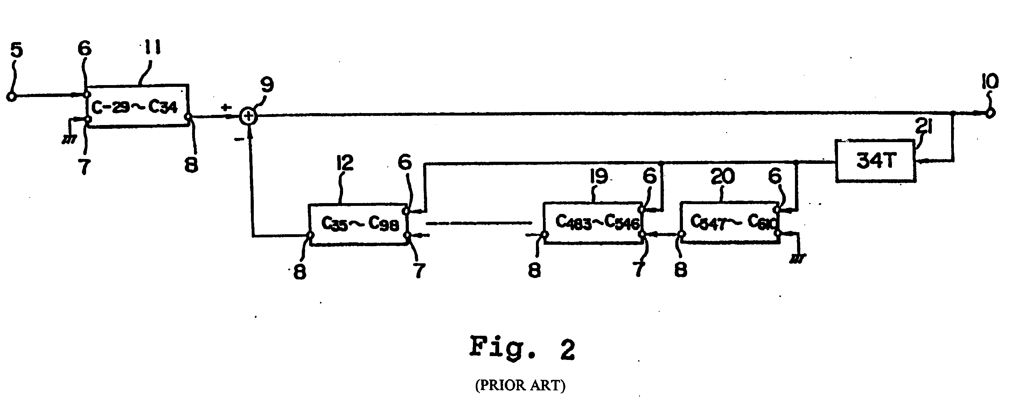

Shown in FIGURE 2 is a block diagram showing a conventional transversal equalizer which has adopted such transversal equalizers. See, for example, "Ghost Image Reducing Tuner and its Operation", Japanese magazine "Chroma", pp. 48-51, (December 1989).

A video signal subjected to disturbance by a ghost image is applied to the input terminal 5. In this input video signal a GCR signal has been inserted.

The incoming video signal is applied to the input terminal 6 of the transversal equalizer 11. The cascade input terminal 7 of the transversal filter 11 is connected to the reference voltage point. Further, the input terminals 6 and 7 correspond to the input terminals 1 and 4 shown in FIGURE 1.

To respective taps of 64 multipliers of the transversal filter 11, not shown, tap coefficients C-29 to C34 are applied. Further, subscripts of the tap coefficients indicate which delay time of clock period T they correspond to.

The coefficient of the main tap corresponding to the rise of the GCR signal is C0 and 1 is set for C0 and 0 for other tap coefficients at the time of initialization. Therefore, in the state of initialization, the transversal filter 11 directly outputs the video signal input to the output terminal from 8 from the input terminal 6.

This transversal filter 11 is of the non-recursive type and a range of delay times from -2 »s (pre-ghost) to 2.4 »s (delayed-ghost) may be provided by the tap coefficients C-29 through C34. That is, cancellation of waveform distortion (waveform equalization) and cancellation of ghost in short delay times (nearby-ghost) are performed by the transversal filter 11.

Output from the transversal filter 11 is applied to the output terminal 10 through the subtractor 9 and at the same time, to the delay unit 21 from the output terminal 10.

Output of the delay unit 21 is applied to the input terminal 6 of each of the transversal filters 12 through 20 in the same construction as the transversal filter 11. The number of taps of the transversal filters 12 through 20 is 64 and tap coefficients C35 through C610 are applied to the transversal filters 12 through 20. That is, the transversal filters 12 through 20 correspond to delayed-ghosts with delay times 2.4 »s through 42.6 »s.

Outputs from respective output terminal 8 of the transversal equalizers 20 through 12 are applied to each cascade input terminal 7 of the transversal filters 19 through 12 in the next stage and the subractor 9, thus forming the recursive filter.

The coefficients C35 through C610 are set at 0 in the initial state and when tap coefficients are corrected thereafter, a ghost cancelling signal is output from the transversal equalizer 12. The subtractor 9 outputs a deghosted video signal to the output terminal 10 after subtracting the ghost cancelling signal from the output of the transversal filter 11.

Tap coefficients C-29 through C610 are obtained through operation of the GCR signal extracted from input and output video signals and reference signal and are successively corrected at specified time intervals. That is, the GCR signal contained in video signal from the input terminal 5 and the GCR signal contained in the video signal from the output terminal 10 are extracted, the GCR signal contained in the output video signal is compared with a reference signal to get an error signal and further, correlated operation of this error signal with GCR signal contained in the input video signal is carried out and tap coefficients are corrected to minimize the error signal.

Further, as described above, the same ICs are used for the transversal filters 11 through 20 to reduce the cost of the equalizer.

As described above, waveform equalization and nearby-ghost image removal are performed by the non-recursive transversal filter 11 and long distant ghost and secondary ghost (see the above-mentioned magazine, "Chroma") produced by this transversal filter 11 are removed by the recursive transversal filters 12 through 20.

Series connection of the non-recursive and recursive transversal equalizers is the construction best suited for the removal of ghost images as shown in the above-mentioned "Chroma".

Generally, if pre-ghost images of delay time less than 2 »s are removed, there will be no problem in practical use. However, the delay time of delayed-ghost images may sometimes be more than 40 »s.

Since the range of delay times for ghost images which can be removed is 44.7 »s as described above, the corresponding range of pre-ghost images was set at -2 »s in the example shown in FIGURE 2. That is, tap coefficients of the transversal filter 11 are from C-29, through C0 to C34.

The circuit is of such a construction that outputs of the transversal filter 11 and the transversal equalizer 12 are subtracted in the subtractor 9 to remove ghost image components and the outputs of the transversal filters 11 and 12 are delayed by T and the delay unit 21 operates for a delay time 34T.

It is, however, considered that with the advancement of integration of digital IC, the number of taps that can be integrated in a single chip will further increase in the future. If so, the number of taps for delayed-ghost images of the transversal filter 11 will be increased.

In this case, therefore, it also becomes necessary to extend the delay time (the number of delay taps) of the delay unit 21 corresponding to the increase in the number of taps in order to delay the outputs of the transversal filters 11 and 12 by T. This will increase the size of the circuit and its cost.

Thus, in the conventional transversal equalizer described above there is the problem that it becomes necessary to increase the delay time of the delay unit and the circuit size becomes large, with a corresponding increase in the number of taps in a single chip.

The present invention therefore seeks to provide a transversal equalizer which is able to reduce the circuit size without requiring a delay unit even when the series connection of cyclic and non-cyclic type transversal equalizers is adopted.

A previously known ghost reduction circuit for a television receiver is shown in EP-A-0 072 247. This circuit comprises one feedforward transversal filter and a subsequent feedback transversal filter, the output of the feedforward transversal filter being input to one of a plurality of combining means in the feedback filter selected by a switch means.

According to one aspect of the present invention there is provided a transversal equalizer comprising:
a first transversal filter comprising:
a first input means for receiving a first equalizer input signal;
a plurality of multiplier means, coupled in parallel to the first input means for respectively multiplying the first equalizer input signal by predetermined coefficients;
a plurality of adder means respectively coupled to outputs of the multiplier means for adding the outputs of the multiplier means;
a plurality of delay means coupled to outputs of respective adder means for delaying outputs thereof;
a first cascade input means coupled to a first adder means of the first transversal filter for receiving a cascade equalizer input signal; and
a first output means coupled to a last of the delay means for outputting a first output signal;
and
a second transversal filter comprising:
a second input means for receiving a second equalizer input signal or the first equalizer input signal;
a plurality of multiplier means, coupled in parallel to the second input means, for respectively multiplying the input signal by predetermined coefficients;
a plurality of adder means respectively coupled to outputs of the multiplier means for adding the outputs of said multiplier means;
a plurality of delay means coupled to outputs of respective adder means for delaying outputs thereof;
an equalizer output means coupled to a last delay means for outputting an equalized output signal; and
a second cascade input means and third cascade input means for inputting a cascade input signal, the second cascade input means being coupled to a first adder means of the second transversal filter, the third cascade input means being coupled to a combining means for adding a cascade input signal to a signal being processed in said second transversal filter, the combining means being coupled to an adder means of the second transversal filter other than the first adder means;
and
a switch means for connecting the first output means of the first transversal filter to either the second cascade input means or the third cascade input means of the second transversal filter.

For a better understanding of the present invention and many of the attendant advantages thereof reference will now be made by way of example to the accompanying drawings, wherein:
Figure 1 is a circuit diagram showing a conventional transversal filter;
Figure 2 is a circuit diagram showing a conventional deghosting apparatus using the transversal filter of Figure 1;
FIGURE 3 is a circuit diagram showing one embodiment of the transversal equalizer according to the present invention; and
FIGURE 4 is a circuit diagram showing an embodiment of the transversal equalizer shown in FIGURE 3 applied to a deghosting apparatus.

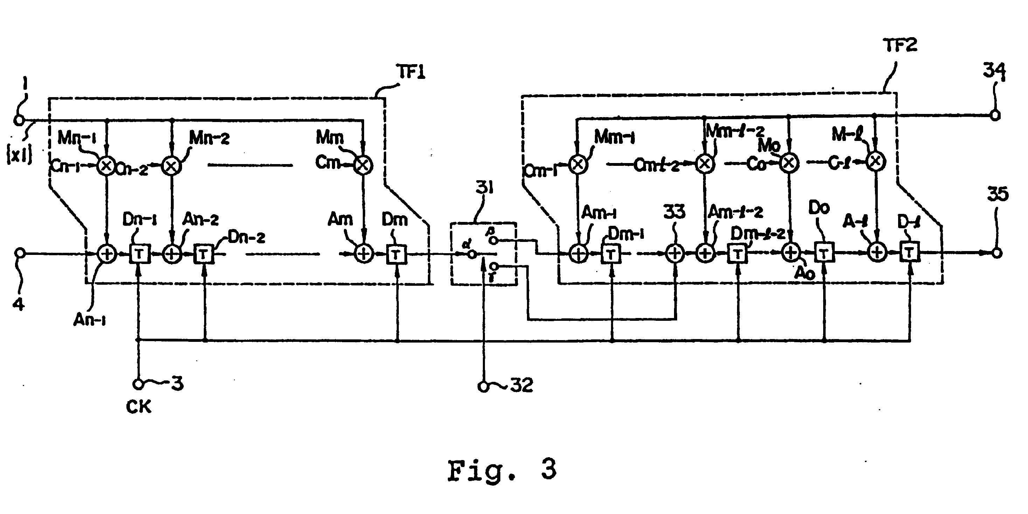

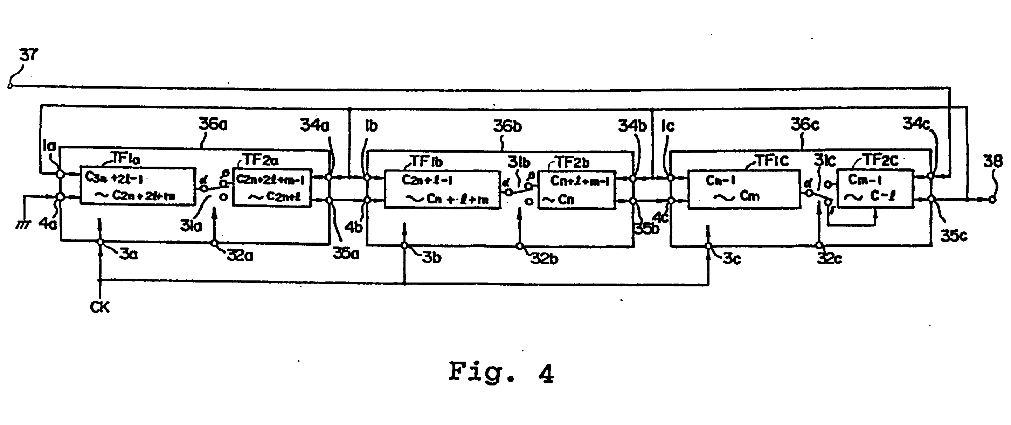

The present invention will be described in detail with reference to the FIGURES 3 and 4. Throughout the drawings, reference numerals or letters used in FIGURES 1 and 2 will be used to designate like or equivalent elements for simplicity of explanation.

Referring now to FIGURE 3, a first embodiment of the transversal equalizer according to the present invention will be described in detail.

The input weighting type transversal filter TF1 enclosed with a broken line is the same construction as the transversal equalizer shown in FIGURE 1. That is, input sample value Xi is applied to the input terminal 1 and this input sample value Xi is applied to the multipliers Mm - Mn-1 having (n-m) taps, where n and m are natural numbers satisfying n-1 > m. To the multipliers Mm through Mn-1, tap coefficients Cm through Cn-1 are applied, respectively.

The multipliers Mm through Mn-1 multiply the input sample value Xi with tap coefficients Cm through Cn-1 and give the results to the adders Am through An-1. Outputs from the adders Am through An-1 are applied to the delay units Dm through Dn-1, respectively. The delay units Dm through Dn-1 the input signals to the terminal a of the switch 31 and the adders Am through An-2 respectively after delaying them by time T.Thus, the adders Am through An-2 add up to delay outputs of the multipliers Mm+1 through Mn-1 in the preceding stage and output them. Further, the output of the transversal equalizer at the preceding stage (not shown) is supplied to cascade terminal 4.

Output of the transversal filter TF1 is applied to the terminal α of the switch 31. The switch 31 selects the terminal β or γ according to a control signal from the input terminal 32. These terminals β and γ operate as the cascade input terminals of the transversal filter TF2.

The transversal filter TF2 has almost the same construction as the transversal filter TF1. The transversal filter TF2 has (m+ℓ) multipliers m-ℓ through Mm-1, (m+ℓ) delay units D-ℓ through Dm-1 and (m+ℓ+1) adders A-ℓ through Am-1 and 33. The signal from the terminal β of the switch 31 is applied to the adder Am-1. Further, ℓ is a natural number.

Input sample value Xi is applied to the input terminal 34. The input sample value Xi is applied to the multipliers M-ℓ through Mm-1. Outputs of these multipliers M-ℓ through Mm-1 are applied to the adders A-ℓ through Am-1 and outputs of the adders A-ℓ through Am-1 are applied to the adders in the next stage through the delay units D-ℓ through Dm-1 in the same way as in the transversal filter TF1. The transversal filter TF2 is provided with the adder 33 between the delay unit Dm-ℓ-1 and the adder Am-ℓ-2. This adder 33 adds the output of the delay unit Dm-ℓ-1 and signal from the terminal γ of the switch 31 and outputs the result to the adder Am-ℓ-2. Output of the delay unit D-ℓ is output to the output terminal 35.

Further, the subscripts of elements of the transversal filters TF1 and TF2 show how many clock periods of delay they correspond to. For instance, tap coefficient C0 shows a coefficient which is multiplied with the main signal when the transversal filter TF2 is connected as a non-recursive filter.

A pre-ghost cancelling signal is generated by ℓ tap coefficients C-ℓ through C-1 applied to the multipliers M-ℓ through M-1 and the post ghost cancelling signal is generated by (m-1) tap coefficients Cm-1 through C1 applied to the multipliers Mm-1 through M1.

When non-recursive and recursive filters are to be connected in series in the embodiment in this construction, the input signal is applied to the input terminal 34 and at the same time, the output terminal 35 is connected to the input terminal 1. Thus, the output is fed back to the input terminal 1.

The transversal equalizer TF2 performs waveform equalization of the input signal based on tap coefficients C-ℓ through Cm-1 and outputs the signal from the output terminal 35. The multipliers M-ℓ through M-1 correspond to, for instance, pre-ghost equalisation and the coefficient M1 through Mm-1 correspond to near-by and delayed ghost equalisation.

In this case, the transversal filter TF2 is in non-recursive construction. Output from the output terminal 35 is fed back to the input terminal 1 and the transversal filter TF1 generates a delayed-ghost cancelling signal based on tap coefficients Cm through Cn-1. Output of the transversal filter TF1 is applied to the adder 33 of the transversal filter TF2 through the terminals α and γ of the switch 31.

Since the adder 33 is arranged just before the adder Am-ℓ-2, total delay amount from the adder 33 (the terminal γ of the switch 31) to the output terminal 35 is (m-1)T. Therefore, there is a delay of time T on the time base between the last tap coefficient Cm-1 of the transversal filter TF2 and the first tap coefficient Cm of the transversal filter TF2.

Thus, the transversal filter TF1 is formed in a recursive structure to enable waveform equalization and ghost image removal by series connection of non-recursive and recursive filters.

On the other hand, the transversal filters TF1 and TF2 become the same type filter with n+1 taps, when the switch 31 selects the terminal β.

FIGURE 4 is a circuit diagram showing an embodiment of the transversal equalizer according to the present invention applied to a deghosting apparatus. In this embodiment, equalizer ICs 36a, 36b are the same construction as the transversal equalizer shown in FIGURE 3, and are connected in series.

The number of taps (n+1) of the transversal equalizer ICs 36a, and 36b is 214 and the total number of taps is 642. Further, ℓ, m and n are, for instance, ℓ = 29, m = 35, and n = 185. The switches 31a and 31b of the transversal equalizer ICs 36a and 36b select the terminal β and the switch 31c of the transversal equalizer Ic 36c selects the terminal γ. To the input terminal 37 a video signal is input. This video signal is applied to the multipliers of the transversal filter TF2c through the input terminal 34c of the transversal equalizer IC 36c.

Outputs from the multipliers of the transversal filter TF2c are added to delayed signals from the multipliers of the preceding stages and output to the next stage. Thus, the transversal filter TF2c removes pre-ghost and nearby-ghost components based on tap coefficients and outputs the video signal from the output terminal 35c.

This video signal is led out to the output terminal 38 and at the same time, applied to the input terminals 1a and 34a of the transversal equalizer IC 36a, the input terminals 1b and 34b of the transversal equalizer IC 36b and the input terminal 1c of the transversal equalizer IC 36c.

The cascade input terminal 4a of the equalizing TC 36a is connected to the reference potential point. The output of transversal filter TF1a is applied to the multipliers of the transversal filter TF2a through the terminals α and β of the switch 31a.

Output of the transversal filter TF2a is applied to the cascade input terminal 4b of the transversal equalizer IC through the output terminal 35a. The output of the transversal filter TF1b is applied to the transversal filter TF2b through the terminals α and β of the switch 31b and output of the transversal filter TF2b is applied to the transversal filter TF1c through the output terminal 35b and the cascade input terminal 4c of the transversal equalizer IC 36c.

Output of the transversal filter TF1c is applied to the transversal filter TF2c through the terminals α and γ of the switch 31c. Further, the input terminals 32a through 32c shown in FIGURE 4 correspond to the input terminals 3 and 32 shown in FIGURE 3.

In the embodiment described above, tap coefficients C-ℓ through Cn-1 are applied to the tape of the transversal equalizer IC 36c. Tap coefficients Cn through Cn+m+ℓ-1 are applied to the taps of the transversal filter TF2b of the transversal equalizer IC 36b and tag coefficients Cn+m+ℓ through C2n+ℓ-1 are applied to the taps of the transversal filter TF1b.

Further, tap coefficients C2n+ℓ through C2n+m+2ℓ-1 are applied to the taps of the transversal filter TF2a of IC36a and tap coefficients C2n+m+2ℓ through C3n+2ℓ-1 are applied to the taps of the transversal filter TF1a.

Output of the transversal filter TF2c of the transversal equalizer Ic 36c is applied to the output terminal 38 and pre-ghost and nearby-ghost image are removed by the non-recursive construction. If the period of clock CK is 69.84 »s, ghost imagesof delay times between -2,0 »s and 2.4 »s are removed by the transversal filter TF2c.

This output is applied to the equalizer ICs 36a and 36b and the transversal filter TF1c and the recursive filtering is performed. Thus, the transversal equalizer ICs 36a and 36b and the transversal filter TF1c remove ghosts of delay times between 2.4 »s and 42.7 »s.

As described above, in this embodiment the transversal filter TF2c is formed in a non-recursive construction to remove pre-ghost and nearby-ghost images and the transversal filters TF1a, TF2a, TF1b, TF2b and TF1c are composed in a recursive construction to remove distant (delayed) ghosts.

Since the output of the transversal filter TF1c is applied to the adder 33 of the transversal filter TF2c, tap coefficient Cm-1 of the transversal filter TF2c and tap coefficient Cm of the transversal filter TF1c become adjacent to each other on the time base and delay unit 21 of the prior art is not required.

Further, the case where the number of taps of the equalizer IC is 214 has been explained above. When equalizer ICs having 320 taps are used, it is apparent that the transversal equalizer IC 36a and 36c only can be used eliminating the transversal equalizer IC 36b.

In the present invention, when the first transversal equalizer is to be formed in a non-recursive construction and the second transversal equalizer in a non-recursive construction, the output from the first transversal equalizer is applied to the adding means and the output from the second transversal equalizer is applied to the first transversal equalizer as an input signal by the switch.

When the adding means adds the output of a multiplier at a position based on the delay amount of the delay unit group to the output of the first transversal equalizer, the last tap coefficient of the second transversal equalizer will be adjacent to the first tap coefficient of the first transversal equalizer on the time base.

Thus, differing from conventional transversal equalizers, it is possible to construct a recursive transversal equalizer requiring no delay unit.

As described above, the present invention can provide an extremely preferable transversal equalizer.

While there have been illustrated and described what are at present considered to be preferred embodiments of the present invention, it will be understood by those skilled in the art that various changes and modifications may be made, and equivalents may be substituted for elements thereof without departing from the true scope of the present invention. In addition, many modifications may be made to adapt a particular situation or material to the teaching of the present invention. Therefore, it is intended that the present invention not be limited to the particular embodiment disclosed as the best mode contemplated for carrying out the present invention, but that the present invention include all embodiments falling within the scope of the appended claims.

## Claims

1. A transversal equalizer comprising:
a first transversal (TF1) filter comprising:
a first input means (1) for receiving a first equalizer input signal;
a plurality of multiplier means (Mn-1 -Mm), coupled in parallel to the first input means (1), for respectively multiplying the first equalizer input signal by predetermined coefficients (Cn-1 -Cm);
a plurality of adder means (An-1 -Am) respectively coupled to outputs of the multiplier means (Mn-1 -Mm) for adding the outputs of the multiplier means (Mn-1 -Mm);
a plurality of delay means (Dn-1 -Dm) coupled to outputs of respective adder means (An-1 -Am) for delaying outputs thereof;
a first cascade input means (4) coupled to a first adder means (An-1) of the first transversal filter for receiving a cascade equalizer input signal; and
a first output means coupled to a last of the delay means (Dm) for outputting a first output signal;
and
a second transversal filter (TF2) comprising:
a second input means (34) for receiving a second equalizer input signal or the first equalizer input signal;
a plurality of multiplier means (Mm-1 -M-1), coupled in parallel to the second input means (34), for respectively multiplying the input signal by predetermined coefficients (Cm-1 - C-1);
a plurality of adder means (Am-1 -A-1) respectively coupled to outputs of the multiplier means (Mm-1 -M-1) for adding the outputs of said multiplier means (Mm-1 -M-1);
a plurality of delay means (Dm-1 - D-1) coupled to outputs of respective adder means (Am-1 -A-1) for delaying outputs thereof;
an equalizer output means (35) coupled to a last delay means (D-1) for outputting an equalized output signal; and
a second cascade input means and third cascade input means for inputting a cascade input signal, the second cascade input means being coupled to a first adder means (Am-1) of the second transversal filter, the third cascade input means being coupled to a combining means (33) for adding a cascade input signal to a signal being processed in said second transversal filter, the combining means being coupled to an adder means of the second transversal filter other than the first adder means;
and
a switch means (31) for connecting the first output means of the first transversal filter to either the second cascade input means or the third cascade input means of the second transversal filter.

2. A transversal equalizer as claimed in claim 1 wherein the first transversal filter (TF1) comprises a larger number of multiplier means than the second transversal filter (TF2).

3. A transversal equalizer as claimed in claim 1 or 2, wherein the switch means (31) further comprises an external control means (32) for externally controlling the connection of the first output means to the second cascade input means or to the third cascade input means.

4. A transversal equaliser as claimed in claim 1 or 2, wherein the first transversal filter (TF1) is recursive and the second transversal filter (TF2) is configurable as either recursive or non-recursive.

5. A transversal equalizer as claimed in claim 4, wherein the second transversal filter (TF2) is configured as recursive when the second input means (34) receives the first equalizer input signal and the switch means (31) connects the first output means of the first transversal filter (TF1) to the second cascade input means of the second transversal filter (TF2).

6. A transversal equalizer as claimed in claim 4, wherein the second transversal filter (TF2) is configured as non-recursive when the second input means (34) receives the second equalizer input signal and the switch means (31) connects the first output means from the first transversal filter (TF1) to the third cascade input means of the second transversal filter (TF2) and the equalizer output means (35) is connected to the first input means (T).

7. A transversal equaliser device, comprising a first transversal equalizer, as claimed in claim 5, and a second transversal equalizer, as claimed in claim 6, wherein the equalizer output means of the first transversal equaliser is connected to the first cascade input means of the second transversal equaliser, and the equaliser output means of the second transversal equaliser is connected to the first and second input means of the first transversal equaliser, and supplies the equalised output signal as the first equaliser input signal to the first transversal filter.

## Patentansprüche

1. Transversalkorrekturfilter, umfassend:
ein erstes Transversalfilter (TF1), umfassend:
eine erste Eingabeeinrichtung (1) zum Empfangen eines ersten Korrekturfiltereingangssignals,
eine Anzahl zur ersten Eingabeeinrichtung (1) parallel geschaltete Multipliziereinrichtungen (Mn-1 -Mm), dazu geeignet, das erste Korrekturfiltereingangssignal jeweils mit vorbestimmten Koeffizienten (Cn-1 -Cm) zu multiplizieren,
eine Anzahl jeweils mit den Ausgängen der Multipliziereinrichtungen (Mn-1 -Mm) verbundene Addierereinrichtungen (An-1 -Am), geeignet zum Addieren der Ausgaben der Multipliziereinrichtungen (Mn-1 -Mm),
eine Anzahl jeweils an die Ausgänge der Addierereinrichtungen (An-1 -Am) angeschlossene Verzögerungseinrichtungen (Dn-1 -Dm), geeignet zum Verzögern der Ausgaben der Addierereinrichtungen (An-1 -Am),
eine erste Kaskadeneingabeeinrichtung (4), die mit einer ersten Addierereinrichtungen (An-1) des ersten Transversalfilters verbunden ist, dazu geeignet, ein Kaskadenkorrekturfiltereingangssignal zu empfangen, und
eine mit der letzten Verzögerungseinrichtung (Dm) verbundene erste Ausgabeeinrichtung, geeignet zum Ausgeben eines ersten Ausgangssignals,
und
ein zweites Transversalfilter (TF2), umfassend:
eine zweite Eingabeeinrichtung (34), geeignet zum Empfangen eines zweiten Korrekturfiltereingangssignals oder des ersten Korrekturfiltereingangssignals,
eine Anzahl zur zweiten Eingabeeinrichtung (34) parallel geschaltete Multipliziereinrichtungen (Mm-1 - M-1), dazu geeignet, das Eingangssignal jeweils mit vorbestimmten Koeffizienten (Cm-1 -C-1) zu multiplizieren,
eine Anzahl jeweils mit den Ausgängen der Multipliziereinrichtungen (Mm-1 -M-1) verbundene Addierereinrichtungen (Am-1 -A-1), geeignet zum Addieren der Ausgaben der Multipliziereinrichtungen (Mm-1 -M-1),
eine Anzahl jeweils mit den Ausgängen der Addierereinrichtungen (Am-1 -A-1) verbundene Verzögerungseinrichtungen (Dm-1 -D-1), geeignet zum Verzögern der Ausgaben der Addierereinrichtungen (Am-1 -A-1),
eine mit der letzten Verzögerungseinrichtungen (D-1) verbundene Korrekturfilterausgabeeinrichtung (35), geeignet zum Ausgeben eines korrekturgefilterten Ausgangssignals, und
eine zweite Kaskadeneingabeeinrichtung und eine dritte Kaskadeneingabeeinrichtung, geeignet zum Eingeben eines Kaskadeneingangssignals, wobei die zweite Kaskadeneingabeeinrichtung mit einer ersten Addierereinrichtungen (Am-1) des zweiten Transversalfilters verbunden ist und die dritte Kaskadeneingabeeinrichtung mit einer Verbindungseinrichtung (33), geeignet zum Addieren eines Kaskadeneingangssignals zu einem Signal, das im zweiten Transversalfilter verarbeitet wird, und die Verbindungseinrichtung an eine Addierereinrichtung des zweiten Transversalfilters angeschlossen ist, die nicht die erste Addierereinrichtung ist,
und
eine Schalteinrichtung (31) zum Verbinden der ersten Ausgabeeinrichtung des ersten Transversalfilters entweder mit der zweiten Kaskadeneingabeeinrichtung oder der dritten Kaskadeneingabeeinrichtung des zweiten Transversalfilters.

2. Transversalkorrekturfilter nach Anspruch 1, wobei das erste Transversalfilter (TF1) eine größere Anzahl Multipliziereinrichtungen enthält als das zweite Transversalfilter (TF2).

3. Transversalkorrekturfilter nach Anspruch 1 oder 2, wobei die Schalteinrichtung (31) zudem eine externe Steuereinrichtung (32) enthält, geeignet zum externen Steuern der Verbindung der ersten Ausgabeeinrichtung mit der zweiten Kaskadeneingabeeinrichtung oder der dritten Kaskadeneingabeeinrichtung.

4. Transversalkorrekturfilter nach Anspruch 1 oder 2, wobei das erste Transversalfilter (TF1) ein rekursives Filter ist, und das zweite Transversalfilter (TF2) als rekursives oder nichtrekursives Filter konfigurierbar ist.

5. Transversalkorrekturfilter nach Anspruch 4, wobei das zweite Transversalfilter (TF2) als rekursives Filter konfiguriert ist, wenn die zweite Eingabeeinrichtung (34) das erste Korrekturfiltereingangssignal empfängt und die Schalteinrichtung (31) die erste Ausgabeeinrichtung des ersten Transversalfilters (TF1) mit der zweiten Kaskadeneingabeeinrichtung des zweiten Transversalfilters (TF2) verbindet.

6. Transversalkorrekturfilter nach Anspruch 4, wobei das zweite Transversalfilter (TF2) als nichtrekursives Filter konfiguriert ist, wenn die zweite Eingabeeinrichtung (34) das zweite Korrekturfiltereingangssignal empfängt und die Schalteinrichtung (31) die erste Ausgabeeinrichtung des ersten Transversalfilters (TF1) mit der dritten Kaskadeneingabeeinrichtung des zweiten Transversalfilters (TF2) verbindet, und die Korrekturfilterausgabeeinrichtung (35) an die erste Eingabeeinrichtung (T) angeschlossen ist.

7. Transversalkorrekturfiltervorrichtung, umfassend ein erstes Transversalkorrekturfilter nach Anspruch 5 und ein zweites Transversalkorrekturfilter nach Anspruch 6, wobei die Korrekturfilterausgabeeinrichtung des ersten Transversalkorrekturfilters mit der ersten Kaskadeneingabeeinrichtung des zweiten Transversalkorrekturfilters verbunden ist, und die Korrekturfilterausgabeeinrichtung des zweiten Transversalkorrekturfilters mit der ersten und der zweiten Eingabeeinrichtung des ersten Transversalkorrekturfilters verbunden ist und das korrekturgefilterte Ausgangssignal als erstes Korrekturfiltereingangssignal in das erste Transversalfilter eingespeist wird.

## Revendications

1. Un égaliseur transversal comportant :
un premier filtre transversal (TF1) comprenant :
un premier moyen d'entrée (1) pour recevoir un premier signal d'entrée de l'égaliseur ;
un ensemble de moyens multiplicateurs (Mn-1 -Mm), reliés en parallèle au premier moyen d'entrée (1) pour multiplier respectivement le premier signal d'entrée de l'égaliseur par des coefficients prédéterminés (Cn-1 -Cm) ;
un ensemble de moyens additionneurs (An-1 -Am), reliés respectivement aux sorties des moyens multiplicateurs (Mn-1 -Mm), pour ajouter les signaux de sortie des moyens multiplicateurs (Mn-1 -Mm) ;
un ensemble de moyens à retard (Dn-1 -Dm), reliés aux sorties des moyens additionneurs respectifs (An-1 -Am), pour retarder leurs signaux de sortie ;
un premier moyen d'entrée en cascade (4), relié à un premier moyen additionneur (An-1) du premier filtre transversal, pour recevoir un signal d'entrée en cascade de l'égaliseur ; et
un premier moyen de sortie, relié à un dernier des moyens à retard (Dm), pour délivrer un premier signal de sortie ;
et
un second filtre transversal (TF2) comprenant :
un second moyen d'entrée (34) pour recevoir un second signal d'entrée de l'égaliseur ou le premier signal d'entrée de l'égaliseur ;
un ensemble de moyens multiplicateurs (Mm-1 -M-1), reliés en parallèle au second moyen d'entrée (34), pour respectivement multiplier le signal d'entrée par des coefficients prédéterminés (Cm-1 -C-1) ;
un ensemble de moyens additionneurs (Am-1 -A1), reliés respectivement aux sorties des moyens multiplicateurs (Mm-1 -M-1), pour ajouter les signaux de sortie desdits moyens multiplicateurs (Mm-1 -M-1) ;
un ensemble de moyens à retard (Dm-1 -D-1), reliés aux sorties des moyens additionneurs respectifs (Am-1 -A-1), pour retarder leurs signaux de sortie ;
un moyen de sortie (35) de l'égaliseur, relié à un dernier moyen à retard (D-1), pour délivrer un signal de sortie égalisé ; et
un second moyen d'entrée en cascade et un troisième moyen d'entrée en cascade pour introduire un signal d'entrée en cascade, le second moyen d'entrée en cascade étant relié à un premier moyen additionneur (Am-1) du second filtre transversal, le troisième moyen d'entrée en cascade étant relié à un moyen combinateur (33) pour ajouter un signal d'entrée en cascade à un signal en cours de traitement dans ledit second filtre transversal, le moyen combinateur étant relié à un moyen additionneur du second filtre transversal autre que le premier moyen additionneur ;
et
un moyen de commutation (31) pour relier le premier moyen de sortie du premier filtre transversal soit au second moyen d'entrée en cascade soit au troisième moyen d'entrée en cascade du second filtre transversal.

2. Un égaliseur transversal comme revendiqué à la revendication 1, dans lequel le premier filtre transversal (TF1) comprend un plus grand nombre de moyens multiplicateurs que le second filtre transversal (TF2).

3. Un égaliseur transversal comme revendiqué à la revendication 1 ou 2, dans lequel le moyen de commutation (31) comprend en outre un moyen de commande externe (32) pour commander extérieurement la liaison du premier moyen de sortie au second moyen d'entrée en cascade ou au troisième moyen d'entrée en cascade.

4. Un égaliseur transversal comme revendiqué à la revendication 1 ou 2, dans lequel le premier filtre transversal (TF1) est récurrent et le second filtre transversal (TF2) peut être configuré comme étant soit récurrent soit non-récurrent.

5. Un égaliseur transversal comme revendiqué à la revendication 4, dans lequel le second filtre transversal (TF2) est configuré comme étant récurrent lorsque le second moyen d'entrée (34) reçoit le premier signal d'entrée de l'égaliseur et le moyen de commutation (31) relie le premier moyen de sortie du premier filtre transversal (TF1) au second moyen d'entrée en cascade du second filtre transversal (TF2).

6. Un égaliseur transversal comme revendiqué à la revendication 4, dans lequel le second filtre transversal (TF2) est configuré comme étant non-récurrent lorsque le second moyen d'entrée (34) reçoit le second signal d'entrée de l'égaliseur et le moyen de commutation (31) relie le premier moyen de sortie du premier filtre transversal (TF1) au troisième moyen d'entrée en cascade du second filtre transversal (TF2) et le moyen de sortie (35) de l'égaliseur est relié au premier moyen d'entrée (T).

7. Un dispositif égaliseur transversal comprenant un premier égaliseur transversal, tel que revendiqué à la revendication 5, et un second égaliseur transversal, tel que revendiqué à la revendication 6, dans lequel le moyen de sortie de l'égaliseur du premier égaliseur transversal est relié au premier moyen d'entrée en cascade du second égaliseur transversal, et le moyen de sortie de l'égaliseur du second égaliseur transversal est relié aux premier et second moyens d'entrée du premier égaliseur transversal, et fournit le signal de sortie égalisé, en tant que premier signal d'entrée de l'égaliseur, au premier filtre transversal.
